**Europäisches Patentamt**

**European Patent Office**

**Office européen des brevets**

(19)

(11) Veröffentlichungsnummer : **0 099 479**
**B1**

(12)            **EUROPÄISCHE PATENTSCHRIFT**

(45) Veröffentlichungstag der Patentschrift :
22.02.89

(51) Int. Cl.⁴ : **H 01 J 37/04**

(21) Anmeldenummer : **83106059.5**

(22) Anmeldetag : **21.06.83**

(54) **Ablenkstruktur für ein Korpuskularstrahl-Austastsystem.**

(30) Priorität : **22.07.82 DE 3227426**

(43) Veröffentlichungstag der Anmeldung :
**01.02.84 Patentblatt 84/05**

(45) Bekanntmachung des Hinweises auf die Patenterteilung : **22.02.89 Patentblatt 89/08**

(84) Benannte Vertragsstaaten :
**DE FR GB NL**

(56) Entgegenhaltungen :
**EP--A-- 0 048 857
JOURNAL OF PHYSICS E, SCIENTIFIC INSTRU-
MENTS, Band 11, 1978, Seiten 529-532, The Institute
of Physics; H.P. FEUERBAUM et al.: "Beam chopper
for subnanosecond pulses in scanning electron
microscopy"**

(73) Patentinhaber : **Siemens Aktiengesellschaft Berlin
und München**.
**Wittelsbacherplatz 2
D-8000 München 2 (DE)**

(72) Erfinder : **Plies, Erich, Dr.
Deisenhofener Strasse 79c
D-8000 München 90 (DE)**

EP 0 099 479 B1

Jouve, 18, rue St-Denis, 75001 Paris, France

## Beschreibung

Die Erfindung betrifft eine Ablenkstruktur mit zwei Ablenkelektroden für ein Korpuskularstrahl-Austastsystem nach dem Oberbegriff der Ansprüche 1 und 6 sowie ein Verfahren zu seinem Betrieb.

Beispielsweise für die stroboskopische Elektronenstrahl-Meßtechnik ist eine hochfrequente Ein- und Abschaltung eines Elektronenstrahls erforderlich. In der Elektronenstrahl-Meßtechnik wird zur Strahlaustastung meist ein Ablenkkondensator verwendet. Ein solches Ablenksystem ist beispielsweise in der Veröffentlichung von H.P. Feuerbaum et al., J. Phys. E : Sci. Instrum., Vol. 11, 1978, 529-532, « Beam chopper for subnanosecond pulses in scanning electron microscopy » beschrieben. Die zwei Ablenkplatten des Ablenkkondensators werden in der Regel beide gleichzeitig mit Pulsen beaufschlagt, wobei jedoch die Spannungen an den beiden Ablenkplatten jeweils entgegengesetztes Vorzeichen aufweisen. Für eine solche sogenannte symmetrische Schaltung der beiden Ablenkplatten des Ablenkkondensators wird ein Pulsgenerator mit zwei Ausgängen, nämlich mit einem « + »- und einem « — »-Ausgang, benötigt.

Es ist technisch einfacher und preiswerter, einen schnellen Pulsgenerator mit nur einem Ausgang zu bauen und damit nur eine einzige Ablenkplatte des Ablenkkondensators mit Spannungspulsen zu beaufschlagen. Dann muß aber die zweite Ablenkplatte des Ablenkkondensators auf eine zeitlich konstante Spannung gelegt werden. Dies erfolgt im allgemeinen dadurch, daß die zweite Ablenkplatte des Ablenkkondensators geerdet wird. Ablenkstrukturen mit einer solchen sogenannten asymmetrischen Beschaltung des Ablenkkondensators sind beispielsweise aus der EP-A-0 048 857 bekannt. Diese sogenannte asymmetrische Beschaltung des Ablenkkondensators, bei der eine Ablenkplatte des Ablenkkondensators auf ein zeitlich konstantes Potential gelegt ist, bewirkt jedoch eine höhere Energieverbreiterung des Korpuskularstrahls durch das gepulste Ablenkfeld, als dies im Fall der zuerst beschriebenen sogenannten symmetrischen Beschaltung des Ablenkkondensators der Fall ist. Eine höhere Energieverbreiterung des Korpuskularstrahls bedingt eine Vergrößerung des Durchmessers der Korpuskularsonde durch die axialen Farbfehler der Linsen, die in Korpuskularstrahlrichtung nach dem Korpuskularstrahl-Austastsystem angeordnet sind. Hand in Hand mit einer Erhöhung der Energiebreite des Korpuskularstrahls wachsen auch die Differenzlaufzeit-Effekte, die eine zeitliche Verschmierung des Korpuskularpulses auf dem Weg zum Target bewirken. Daher wird die sogenannte asymmetrische Beschaltung des Ablenkkondensators praktisch nicht eingesetzt.

Der vorliegenden Erfindung liegt die Aufgabe zugrunde, eine Ablenkstruktur der eingangs genannten Art anzugeben, mit der die im Strahlaustastsystem durch die asymmetrische Potentialbelegung der Ablenkelektroden erzeugte Energieverbreiterung des Korpuskularstrahls reduziert wird.

Diese Aufgabe wird erfindungsgemäß durch eine Ablenkstruktur nach dem Oberbegriff des Anspruchs 1 gelöst, welche die kennzeichnenden Merkmale des Anspruchs 1 oder des Anspruchs 6 aufweist.

Ausgestaltungen und Vorteile der Erfindung sind in den Unteransprüchen, der Beschreibung und der Zeichnung dargestellt und beschrieben.

Ausführungsbeispiele der Erfindung sind in der Zeichnung dargestellt und werden im folgenden näher beschrieben.

Fig. 1 zeigt das elektrische Feldlinien-Bild bei symmetrischer Beschaltung der Ablenkelektroden (Ablenkplatten) eines Ablenkkondensators.

Fig. 2 zeigt die zugehörige Feldstärke auf der optischen Achse.

Fig. 3 zeigt das elektrische Feldlinien-Bild bei asymmetrischer Beschaltung der Ablenkelektroden (Ablenkplatten) eines Ablenkkondensators.

Fig. 4 zeigt die zugehörige Feldstärke auf der optischen Achse.

Fig. 5 zeigt das elektrische Feldlinien-Bild bei asymmetrischer Beschaltung der Ablenkelektroden (Ablenkplatten) und erfindungsgemäßen Zusatzelektroden.

Fig. 6 zeigt idealisierte Spannungspulse für symmetrische Beschaltung der Ablenkelektroden (Ablenkplatten) eines Ablenkkondensators.

Fig. 7 zeigt einen idealisierten Spannungspuls für asymmetrische Beschaltung der Ablenkelektroden (Ablenkplatten) eines Ablenkkondensators.

Fig. 8 zeigt eine erfindungsgemäße Ablenkstruktur mit abgewinkelten Zusatzelektroden.

Die Ausführungsbeispiele werden anhand eines Elektronenstrahl-Austastssystems beschrieben. Dennoch ist die Erfindung keineswegs auf Elektronenstrahl-Austastsysteme beschränkt, sondern kann auf beliebige Korpuskularstrahl-Austastsysteme angewandt werden. Da das Austastfeld eines Elektronenstrahl-Austastsystems zeitlich veränderlich ist, wird die Gesamtenergie eines Elektrons — in Strahlrichtung gesehen — vor dem Austastfeld nicht notwendigerweise gleich der Gesamtenergie des Elektrons nach dem Austastfeld sein, auch wenn die elektrischen Potentiale in Strahlrichtung gesehen vor und nach dem Austastsystem gleich sind. Denn das Elektron kann im elektrischen Feld des Austastsystems Energie aufnehmen oder aber auch welche abgeben. Bei explizit zeitabhängigem Potential $\varphi(\overline{r}, t)$ gilt für die Änderung der Gesamtenergie $E_{ges}$ eines Elektrons mit der Ladung — e, welches sich in diesem explizit zeitabhängigen Potential $\varphi(\overline{r}, t)$ befindet :

$$\frac{dE_{ges}}{dt} = -e\frac{\partial\varphi(\vec{r}\cdot t)}{\partial t}. \tag{1}$$

Diese Gleichung (1) besagt, daß die Gesamtenergie des Elektrons nur dann konstant ist, wenn das elektrische Potential $\varphi$ nicht explizit von der Zeit abhängt. Im zeitlich veränderlichen äußeren elektrischen Feld $\vec{E}(\vec{r}, t)$ :

$$\vec{E}(\vec{r}, t) = -\operatorname{grad}\varphi(\vec{r}, t)$$

gilt für die Änderung der kinetischen Energie $E_{kin}$ des Elektrons :

$$\frac{dE_{kin}}{dt} = -e\,\vec{v}(\vec{r}, t)\vec{E}(\vec{r}, t), \tag{2}$$

wobei $\vec{v}$ der Geschwindigkeitsvektor des Elektrons ist. Integration über die Zeit t bei Gleichung (2) liefert die Änderung der kinetischen Energie und damit die Energieverbreiterung des Elektronenstrahls durch das gepulste Ablenkfeld beim Durchlaufen des Austastsystems :

$$\Delta E_{kin} = E_{kin,\,Ende} - E_{kin,\,Anfang} = -e\int_{t_{Anfang}}^{t_{Ende}} \vec{v}(\vec{r}(t), t)\vec{E}(\vec{r}(t), t)\,dt \tag{3}$$

$t_{Ende} - t_{Anfang}$ ist die Einwirkzeit des Austastfeldes des Austastsystems auf ein Elektron des Elektronenstrahls. Diese Einwirkzeit ist im allgemeinen für verschiedene Elektronen des Elektronenstrahls unterschiedlich, je nachdem zu welchem Zeitpunkt das betreffende Elektron zwischen Einschalt- und Abschaltzeitpunkt des elektrischen Pulses, welcher an die Ablenkstruktur des Austastsystems angelegt wird, das Ablenksystem passiert. Für $\vec{r} = \vec{r}(t)$ ist in Gleichung (3) die Elektronenbahn einzusetzen.

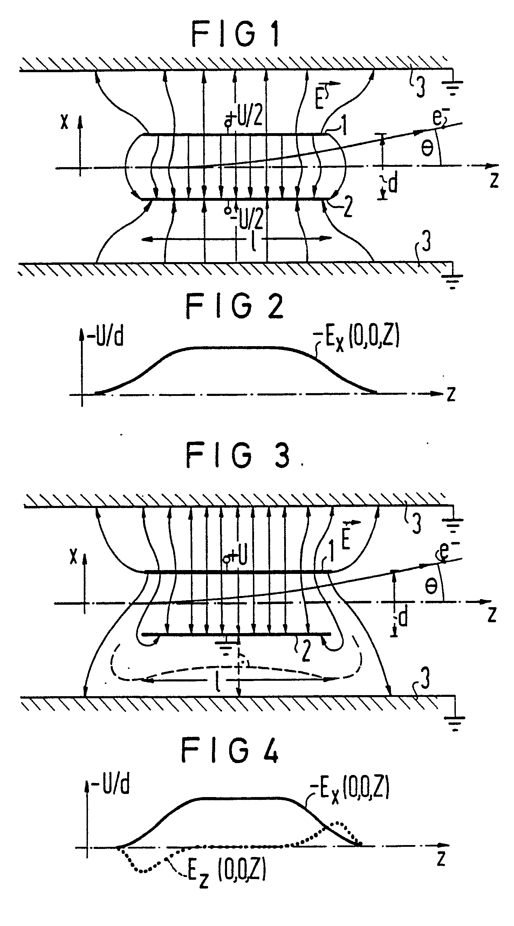

Fig. 1 zeigt das elektrische Feldlinien-Bild bei symmetrischer Beschaltung der Ablenkelektroden 1, 2 der Ablenkstruktur. An die Ablenkelektrode (Ablenkplatte) 1 ist bei dieser symmetrischen Beschaltung die Spannung + U/2 und an die Ablenkelektrode 2 ist die Spannung — U/2 angelegt. Der Abstand der beiden Ablenkelektroden 1, 2 beträgt d. Die Länge der Ablenkelektroden 1, 2 in Strahlrichtung beträgt 1. Die Strahlrichtung und damit die optische Achse des Systems verlaufen in z-Richtung eines kartesischen Koordinatensystems. Senkrecht zur z-Richtung verlaufen die x-Richtung und die y-Richtung. Die Ablenkelektroden 1, 2 befinden sich innerhalb einer symmetrischen, geerdeten Umgebung 3. Die Elektronen des das Austastsystem passierenden Elektronenstrahls erleiden infolge des Austastfeldes den Ablenkwinkel $\theta$.

Fig. 2 zeigt die zu Fig. 1 gehörige Feldstärke auf der optischen Achse. Auf der optischen Achse ist in Fig. 1 nur die Feldstärke $E_x = -U/d$ verschieden von Null, unabhängig davon, ob die Ablenkelektroden freistehen oder von der symmetrischen, geerdeten Umgebung 3 benachbart sind. Da die optische Achse mit der z-Achse zusammenfällt, weist die elektrische Feldstärke $E_x$ auf der optischen Achse nur eine z-Abhängigkeit auf.

Fig. 3 zeigt das elektrische Feldlinien-Bild bei asymmetrischer Beschaltung der Ablenkelektroden 1, 2 der Ablenkstruktur und geerdeter Umgebung 3. Die Ablenkelektrode 1 wird mit der Spannung + U beaufschlagt, die Ablenkelektrode 2 ist geerdet. Die übrigen Bezeichnungen stimmen mit den Bezeichnungen in Fig. 1 überein. Eine geerdete Umgebung 3 ist in einer elektronenoptischen Säule immer vorhanden. Wie aus Fig. 3 leicht ersichtlich ist, hat das Randfeld des Plattenkondensators, der aus den Ablenkelektroden 1 und 2 besteht, auch auf der optischen Achse eine z-Komponente des elektrischen Feldes $E_z$ verschieden von Null.

Fig. 4 zeigt die zu Fig. 3 gehörige Feldstärke $\vec{E}$ auf der optischen Achse. Die $E_x$-Komponente des elektrischen Feldes auf der optischen Achse zeigt etwa dasselbe Verhalten wie bei symmetrischer Beschaltung der Ablenkelektroden 1, 2. Die $E_z$-Komponente des elektrischen Feldes ist bei asymmetrischer Beschaltung der Ablenkelektroden 1, 2 verschieden von Null im Gegensatz zur symmetrischen Beschaltung in Fig. 1.

Im Ablenkschnitt (x-z-Ebene) ist sowohl bei symmetrischer Beschaltung der Ablenkelektroden 1, 2 nach Fig. 1 als auch bei asymmetrischer Beschaltung der Ablenkelektroden 1, 2 nach Fig. 3 die Komponente $E_y$ der Feldstärke im Ablenkplattenkondensator gleich Null. Daher reduziert sich die Gleichung (3) auf :

$$\Delta E_{kin} = -e\int_{t_{Anfang}}^{t_{Ende}} \left\{v_x(\vec{r}, t)\,E_x(\vec{r}, t) + v_z(\vec{r}, t)\,E_z(\vec{r}, t)\right\}dt \tag{4}$$

Der Ablenkwinkel $\theta$ infolge des Strahlaustast-Feldes $\vec{E}$ hat die Größenordnung der Strahlapertur $\alpha$ im Austastsystem. Diese Strahlapertur $\alpha$ beträgt z. B. im Austastsystem des Elektronenstrahlgerätes Cambridge S150 $10^{-2}$ rad. Wegen der Relation :

$$\frac{v_x}{v_z} \leq \left( \frac{v_x}{v_z} \right)_{Ende} = \theta \approx \alpha \ll 1$$

kann in Gleichung (4) der erste Summand vernachlässigt werden. Wegen $v_z = dz/dt$ ergibt sich :

$$\Delta E_{kin} \approx - e \int_{t_{Anfang}}^{t_{Ende}} v_z E_z \, dt = - e \int_{z_{Anfang}}^{z_{Ende}} E_z(\vec{r}, t) \, dz .$$
(5)

Die z-Komponente des elektrischen Feldes $\vec{E}$ im Ablenkschnitt (x-z-Ebene), $E_z(\vec{r}, t) = E_z(x, o, z, t)$, kann näherungsweise durch eine abgebrochene Taylorentwicklung bezüglich der x-Abhängigkeit dargestellt werden. Unter der zusätzlichen Annahme, daß infolge des zeitlich veränderlichen elektrischen Austastfeldes $\vec{E}$ induzierte elektrische Wirbelfelder vernachlässigt werden können, kann der Verlauf der Komponente $E_x$ des elektrischen Ablenkfeldes $\vec{E}$ in den zweiten Term der Reihenentwicklung für die Komponente $E_z$ des elektrischen Ablenkfeldes $\vec{E}$ eingeführt werden :

$$E_z \approx E_z|_{x=0} + \frac{\partial E_x}{\partial z} \bigg|_{x=0} \cdot x .$$
(6)

Im Fall der symmetrischen Beschaltung der Ablenkelektroden 1, 2 nach Fig. 1 ist die Komponente $E_z|_{x=0} = $ Null und für die Energieverbreiterung des Elektronenstrahls ergibt sich aus den Gleichungen (5) und (6) :

$$\Delta E_{kin} \approx - e \int_{z_{Anfang}}^{z_{Ende}} \frac{\partial E_x}{\partial z} \bigg|_{x=0} \cdot x \, dz .$$
(7)

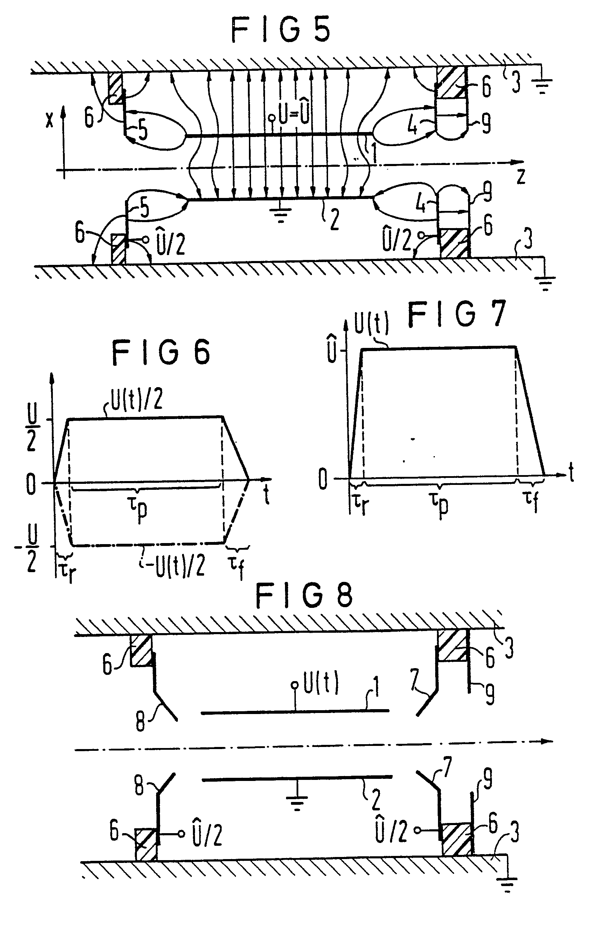

Im Eingangsrandfeld des Plattenkondensators des Austastsystems ist $x \approx 0$, so daß nur das Ausgangsrandfeld des Plattenkondensators des Austastsystems einen Beitrag zur Energieverbreiterung liefert. Die maximale Energieänderung der kinetischen Energie erfährt dasjenige Elektron des Elektronenstrahls, welches während der Pulsdauer $\tau_p$ (siehe Fig. 6) gerade das gesamte Ausgangsrandfeld des Plattenkondensators des Ausgangssystems durchläuft. Der Wert dieser maximalen Energieänderung hängt schwach vom spezifischen Randfeldabfall des jeweiligen Plattenkondensators ab. Mit dem Mittelwertsatz der Integralrechnung kann der Maximalwert der Energieänderung von Gleichung (7) jedoch grob abgeschätzt werden :

$$\Delta E_{kin}|_{max} \approx - e \frac{\hat{U}/d}{d} \frac{1}{2} \theta d = - e \frac{\hat{U}l}{2 d} \theta .$$
(8)

Mit $\hat{U}$ ist die Amplitude des an den Ablenkelektroden 1, 2 des Plattenkondensators anliegenden Austastsignals bezeichnet. Das Minuszeichen in Gleichung (8) bedeutet eine Verzögerung des Elektrons, was anhand der Fig. 1 leicht eingesehen werden kann. Wenn in Gleichung (8) für die Größe $\hat{U}$ 10 V eingesetzt werden, für das Verhältnis l/d ein Wert von 10 und für den Ablenkwinkel $\theta$ ein Wert von $2 \cdot 10^{-2}$ rad, so erhält man eine maximale Energieänderung $\Delta E_{kin}|_{max} \approx -1$ eV.

Im Fall der asymmetrischen Beschaltung der Ablenkelektroden 1, 2 des Plattenkondensators des Austastsystems nach Fig. 3 ist die z-Komponente $E_z$ der elektrischen Feldstärke $\vec{E}$ auf der optischen Achse nicht mehr Null :

$$E_z|_{x=0} \neq 0 .$$

In der Gleichung (6) mit der Reihenentwicklung kann dann der zweite Summand vernachlässigt werden und die Gleichungen (5) und (6) ergeben dann zusammen :

$$\Delta E_{kin} \approx - e \int_{z_{Anfang}}^{z_{Ende}} E_z|_{x=0} \, dz .$$
(9)

Da nach Fig. 3 und Fig. 4 die Feldkomponente $E_z|_{x=0}$ im Eingangsrandfeld und Ausgangsrandfeld des Plattenkondensators des Austastsystems entgegengesetztes Vorzeichen hat, wird die Energieänderung der kinetischen Energie nach Gleichung (9) Null für ein Elektron, das bei eingeschaltetem Puls beide Randfelder des Plattenkondensators durchläuft. (Da bei der Ableitung von Gleichung (9) der zweite Term in Gleichung (6) vernachlässigt worden ist, gilt genauer gesagt, daß die Energieänderung eines solchen Elektrons, das bei eingeschaltetem Puls beide Randfelder des Plattenkondensators durchläuft, so groß bleibt wie bei der symmetrischen Beschaltung nach Fig. 1.) Ein Elektron, das bei eingeschaltetem Puls nur das Eingangsrandfeld durchläuft, wird bei asymmetrischer Beschaltung des Plattenkondensators maximal beschleunigt, während ein Elektron, das bei eingeschaltetem Puls nur das gesamte Ausgangsrandfeld des Plattenkondensators durchläuft, um denselben Energiebetrag maximal verzögert wird. Der Verlauf von $E_z|_{x=0}$ längs der optischen Achse hängt stark von der Entfernung und der Gestalt der geerdeten Umgebung 3 ab. Für eine grobe Abschätzung des Verlaufs dieser Komponente $E_z$ auf der optischen Achse kann angenommen werden, daß das elektrische Feld $\bar{E}$ im Randfeld des Plattenkondensators die z-Achse unter ca. 60° schneidet und daß die Komponente $E_z$ den Näherungswert $\hat{U} \cdot \cos 60°/d$ über eine effektive Ausdehnung von d auf der optischen Achse besitzt. Dann ergibt sich mit Gleichung (9) für die maximale Energieänderung eines Elektrons

$$\Delta E_{kin}|_{max} \simeq \pm e \frac{\hat{U}}{2} \approx \pm 5\,eV \qquad \text{für} \qquad \hat{U} = 10\,V\,.$$

Dies bedeutet, daß die Energieverbreiterung des Elektronenstrahls bei asymmetrischer Beschaltung der Ablenkelektroden 1, 2 des Ablenksystems bei den gemachten Annahmen etwa um eine Größenordnung größer ist als bei symmetrischer Beschaltung der Ablenkelektroden 1, 2 des Austastsystems nach Fig. 1.

Fig. 5 zeigt das elektrische Feldlinien-Bild bei asymmetrischer Beschaltung der Ablenkelektroden 1, 2 des Ablenksystems und erfindungsgemäßen Zusatzelektroden 4, 5. Werden bei asymmetrischer Beschaltung in beiden Randfeldern des Plattenkondensators des Austastsystems Zusatzelektroden 4, 5 angebracht und wird an diese Zusatzelektroden 4, 5 das Potential der optischen Achse im Innern des Plattenkondensators des Ablenksystems, also U/2, angelegt, so kann erreicht werden, daß die Feldkomponente $E_z$ auf der optischen Achse wieder verschwindet, wie dies bei der symmetrischen Beschaltung nach Fig. 1 der Fall ist. Am einfachsten ist es, als Zusatzelektroden 4, 5 eine Schlitz- oder Lochblende, wie in der linken Hälfte von Fig. 5 dargestellt, zu verwenden. Damit die Feldkomponente $E_z$ auf der optischen Achse immer Null ist, müßten diese Zusatzelektroden 4, 5 genau genommen das zeitlich veränderliche Potential U(t)/2 haben. Es genügt jedoch, diese Zusatzelektroden 4, 5 statisch mit der Spannung $\hat{U}/2$ zu versorgen, denn dann ist beim zeitlich veränderlichen Ablenkfeld $\bar{E}$ das Verschwinden der Komponente $E_z$ auf der optischen Achse nur während der Pulsanstiegszeit $\tau_r$ und der Pulsabfallzeit $\tau_f$ des an die Ablenkelektrode 1 angelegten elektrischen Pulses U(t) verletzt. Die Pulsanstiegszeit und die Pulsabfallzeit sind in der Regel aber klein gegen die Pulsdauer $\tau_p$ (siehe Fig. 6). Für den Fall, daß sowohl die Pulsanstiegszeit $\tau_r$ als auch die Pulsabfallzeit $\tau_f$ gegen die Pulsdauer $\tau_p$ vernachlässigt werden können, erreicht die verbleibende Energieverbreiterung des Elektronenstrahls näherungsweise den Wert für symmetrische Beschaltung der Ablenkelektroden 1, 2 des Austastsystems.

Es ist zu beachten, daß durch die Zusatzelektrode 4, 5 mindestens schwache statische Zylinderlinsenfelder und bei Verwendung von rotationssymmetrischen Zusatzelektroden 4, 5 noch schwache statische Rundlinsenfelder erzeugt werden. Die Wirkungen dieser Felder lassen sich aber durch einen — sowieso vorhandenen — statischen Stigmator und eine Fokussierungsänderung an den eingebauten Rundlinsen der elektronenoptischen Säule kompensieren. In der rechten Hälfte von Fig. 5 wurde noch eine zusätzliche geerdete Elektrode 9 vorgesehen, um die Ausdehnung der statischen Zusatzfelder stärker zu begrenzen. Die Zusatzelektroden 4, 5 sind über Isolatoren 6 an der geerdeten Umgebung 3 befestigt. Geerdete Elektroden 9 können auch allein bei den Zusatzelektroden 5 oder sowohl bei den Zusatzelektroden 4 als auch bei den Zusatzelektroden 5 angeordnet werden.

Fig. 6 zeigt idealisierte Spannungspulse für die symmetrische Beschaltung der Ablenkelektroden 1, 2 eines Austastsystems nach Fig. 1. An der Ablenkelektrode 1 steigt der Puls während der Anstiegszeit $\tau_r$ linear auf den Wert $\hat{U}/2$ an, behält diesen Wert $\hat{U}/2$ während der Pulsdauer $\tau_p$ bei und fällt wiederum während der Pulsabfallzeit $\tau_f$ linear auf den Wert Null ab. An der Ablenkelektrode 2 wird gleichzeitig ein Spannungspuls angelegt, der sich von dem Spannungspuls an der Ablenkelektrode 1 nur dadurch unterscheidet, daß er das entgegengesetzte Vorzeichen aufweist.

Fig. 7 zeigt einen idealisierten Spannungspuls für asymmetrische Beschaltung der Ablenkelektroden 1, 2 der Ablenkstruktur nach Fig. 3. Während die Ablenkelektrode 2 ständig geerdet ist, wird an die Ablenkelektrode 1 eine Spannung U(t) angelegt, die während der Pulsanstiegszeit $\tau_r$ linear von Null auf den Wert $\hat{U}$ ansteigt, diesen Wert $\hat{U}$ während der Pulsdauer $\tau_p$ beibehält und während der Pulsabfallzeit $\tau_f$ wiederum linear auf den Wert Null abfällt.

Fig. 8 zeigt abgewinkelte Zusatzelektroden 7, 8 zur Verringerung der Energieverbreiterung bei asymmetrischer Beschaltung der Ablenkelektroden 1, 2. Natürlich können anstelle der planen Zusatzelektroden 4, 5 von Fig. 5 auch andersartige Zusatzelektroden, z. B. abgewinkelte Zusatzelektroden 7, 8 verwendet werden. Auch bei einer Anordnung nach Fig. 8 können zusätzliche geerdete Elektroden 9 ganz weggelassen werden oder jeweils nur bei den Zusatzelektroden 7 oder nur bei den Zusatzelektroden 8 angeordnet werden oder auch sowohl in der Nähe der Zusatzelektroden 7 als auch in der Nähe der Zusatzelektroden 8 angeordnet werden.

Mit der Verringerung der Energieverbreiterung des Elektronenstrahls geht Hand in Hand eine Verringerung von Differenzlaufzeit-Effekten der Elektronen, womit einer zeitlichen Verschmierung des Elektronenpulses entgegengewirkt wird. Beim hochfrequenztechnischen Design des Strahlaustastsystems müssen die Zusatzelektroden 4, 5, 7, 8 mit berücksichtigt werden, damit keine Pulsreflexionen oder andere unerwünschte Effekte entstehen.

Durch Zusatzelektroden 4, 5, 7, 8 am Ein- und Ausgang des asymmetrisch geschalteten Ablenkkondensators des Austastsystems wird die beim Stand der Technik auftretende höhere Energieverbreiterung erfindungsgemäß weitgehend auf die geringere Energieverbreiterung bei symmetrischer Beschaltung der Ablenkelektroden 1, 2 nach Fig. 1, bei der ein teurer Pulsgenerator mit sowohl positivem als auch negativem Ausgang verwendet wird, reduziert. Die Zusatzelektroden 4, 5, 7, 8 werden erfindungsgemäß beispielsweise statisch mit dem Spannungswert $\hat{U}/2$ versorgt, wobei $\hat{U}$ die Amplitude des an den Ablenkelektroden 1, 2 anliegenden Austastsignals bezeichnet.

**Patentansprüche**

1. Ablenkstruktur für ein Korpuskularstrahl-Austastsystem mit einer auf einem zeitlich veränderlichen ersten Potential (U(t)) liegenden ersten Ablenkelektrode (1) und einer auf einem konstanten zweiten Potential liegenden zweiten Ablenkelektrode (2), gekennzeichnet durch eine am Eingang der Ablenkstruktur angeordnete erste Zusatzelektrode (5, 8) und eine am Ausgang der Ablenkstruktur angeordnete zweite Zusatzelektrode (4, 7) die jeweils auf einem konstanten Potential liegen, dessen Amplitude etwa der Hälfte der Amplitude ($\hat{U}$) des ersten Potentials (U(t)) bezogen auf das Potential der zweiten Ablenkelektrode entspricht.

2. Ablenkstruktur nach Anspruch 1, dadurch gekennzeichnet, daß mindestens eine der Zusatzelektroden (4, 5, 7, 8) als Schlitzblende ausgebildet ist.

3. Ablenkstruktur nach Anspruch 1 oder 2, dadurch gekennzeichnet, daß mindestens eine der Zusatzelektroden (4, 5, 7, 8) als Lochblende ausgebildet ist.

4. Ablenkstruktur nach einem der Ansprüche 1 bis 3, dadurch gekennzeichnet, daß weitere auf Erdpotential liegende Elektroden (9) zur Begrenzung der Ausdehnung der statischen Zusatzfelder vorgesehen sind.

5. Ablenkstruktur nach einem der Ansprüche 1 bis 4, dadurch gekennzeichnet, daß mindestens eine der Zusatzelektroden (4, 5, 7, 8) abgewinkelt ist.

6. Ablenkstruktur für ein Korpuskularstrahl-Austastsystem mit einer auf einem zeitlich veränderlichen ersten Potential (U(t)) liegenden ersten Ablenkelektrode (1) und einer auf einem konstanten zweiten Potential liegenden zweiten Ablenkelektrode (2), gekennzeichnet durch eine am Eingang der Ablenkstruktur angeordnete erste Zusatzelektrode (5, 8) und eine am Ausgang der Ablenkstruktur angeordnete zweite Zusatzelektrode (4, 7) die jeweils auf einem Potential liegen, das etwa dem 0,5-fachen des ersten Potentials (U(t)) bezogen auf das Potential der zweiten Ablenkelektrode entspricht.

7. Ablenkstruktur nach einem der Ansprüche 1 bis 6, dadurch gekennzeichnet, daß die Wirkungen der durch die Zusatzelektroden (4, 5, 7, 8) hervorgerufenen Zylinderlinsenfelder oder Rundlinsenfelder mittels eines Stigmators und einer Fokussierungsänderung an den Rundlinsen der korpuskularoptischen Anordnung kompensiert werden.

**Claims**

1. Deflection structure for a particle beam blanking system with a first deflection electrode (1) which is at a time-variable first potential (U(t)) and a second deflection electrode (2) which is at a constant second potential, characterized by a first additional electrode (5, 8) which is arranged at the input of the deflection structure and a second additional electrode (4, 7) which is arranged at the output of the deflection structure and which are in each case at a constant potential, the amplitude of which corresponds to about one half of the amplitude ($\hat{U}$) of the first potential (U(t)) referred to the potential of the second deflection electrode.

2. Deflection structure according to Claim 1, characterized in that at least one of the additional electrodes (4, 5, 7, 8) is constructed as slotted diaphragm.

3. Deflection structure according to one of Claims 1 or 2, characterized in that at least one of the additional electrodes (4, 5, 7, 8) is constructed as pinhole diaphragm.

4. Deflection structure according to one of Claims 1 to 3, characterized in that further electrodes (9), which are at earth potential, are provided for limiting the extent of the additional static fields.

5. Deflection structure according to one of Claims 1 to 4, characterized in that at least one of the additional electrodes (4, 5, 7, 8) is angled away.

6. Deflection structure for a particle beam blanking system with a first deflection electrode (1) which is at a time-variable first potential (U(t)) and a second deflection electrode (2) which is at a constant second potential, characterized by a first additional electrode (5, 8) arranged at the input of the deflection structure and a second additional electrode (4, 7) which is arranged at the output of the deflection structure, which are in each case at a potential which corresponds to about 0.5-times the first potential (U(t)) referred to the potential of the second deflection electrode.

7. Deflection structure according to one of Claims 1 to 6, characterized in that the effects of the cylindrical lens fields or round lens fields produced by the additional electrodes (4, 5, 7, 8) are compensated by means of a stigmator and a change of focusing at the round lenses of the particle-optical arrangement.

**Revendications**

1. Structure de déflexion pour un système de suppression d'un faisceau corpusculaire comportant une première électrode déflectrice (1) située à un premier potentiel (U(t)) variable dans le temps, et une seconde électrode déflectrice (2) située à un second potentiel constant, caractérisée par une première électrode supplémentaire (5, 8) disposée à l'entrée de la structure de déflexion, et une seconde électrode supplémentaire (4, 7) située à la sortie de la structure de déflexion, ces électrodes étant placées respectivement à un potentiel constant dont l'amplitude correspondant approximativement à la moitié de l'amplitude (Û) du premier potentiel (U(t)), rapportée au potentiel de la seconde électrode déflectrice.

2. Structure de déflexion suivant la revendication 1, caractérisé par le fait qu'au moins l'une des électrodes supplémentaires (4, 5, 7, 8) est réalisée sous la forme d'un diaphragme à fente.

3. Structure de déflexion suivant la revendication 1 ou 2, caractérisée par le fait qu'au moins l'une des électrodes supplémentaires (4, 5, 7, 8) est réalisée sous la forme d'un diaphragme à trou.

4. Structure de déflexion suivant l'une des revendications 1 à 3, caractérisée par le fait que d'autres électrodes (9) placées au potentiel de terre sont prévues pour limiter l'étendue des champs statiques supplémentaires.

5. Structure de déflexion suivant l'une des revendications 1 à 4, caractérisée par le fait qu'au moins l'une des électrodes supplémentaires (4, 5, 7, 8) est coudée.

6. Structure de déflexion pour un système de suppression d'un faisceau corpusculaire comportant une première électrode déflectrice (1) située à un premier potentiel (U(t)) variable dans le temps, et une seconde électrode déflectrice (2) située à un second potentiel constant, caractérisée par une première électrode supplémentaire (5, 8) disposée à l'entrée de la structure de déflexion et une seconde électrode supplémentaire (4, 7) disposée à la sortie de la structure de déflexion, ces électrodes étant placées respectivement à un potentiel qui correspond à environ 0,5 fois le premier potentiel (U(t)), rapporté au potentiel de la seconde électrode déflectrice.

7. Structure de déflexion suivant l'une des revendications 1 à 6, caractérisé par le fait que les actions des champs de lentilles cylindriques de deux champs de lentilles circulaires, provoqués par les électrodes supplémentaires (4, 5, 7, 8), sont compensées au moyen d'un stigmateur et d'une modification de la focalisation dans les lentilles circulaires du dispositif d'optique corpusculaire.

EP 0 099 479 B1

FIG 1

FIG 2

FIG 3.

FIG 4

## F I G 5

## F I G 6

## F I G 7

## F I G 8